# EUROPEAN PATENT APPLICATION

(11) **EP 4 765 459 A1**
(43) Date of publication of application: **24.06.2026**
(21) Application number: 25822423.7
(22) Date of filing: 06.02.2025
(51) Int. Cl.: H01M 50/569, H01M 50/502, H01M 50/516, H05K 1/14, H01M 50/507, H01M 50/249

(54) **BATTERY PACK AND VEHICLE INCLUDING SAME**

(30) Priority: 12.06.2024 KR 20240076631
(71) Applicant: LG Energy Solution, Ltd., Seoul 07335 (KR)
(72) Inventor: JO, Yong-Hyuck, Daejeon 34122 (KR); AHN, Jun-Young, Daejeon 34122 (KR); YANG, Jin-Oh, Daejeon 34122 (KR); LEE, Yong-Ho, Daejeon 34122 (KR); JUNG, In-Hyuk, Daejeon 34122 (KR)
(74) Representative: Plasseraud IP
(86) International application number: PCT/KR2025/001774
(87) International publication number: WO 2025/258790

(57) **Abstract**

A battery pack according to the present disclosure includes: a plurality of battery cells; a bus-bar assembly connected to the battery cells; and at least one sensing assembly connected to the bus-bar assembly, wherein the sensing assembly may include: a sensing member including at least one sensing branch configured to sense at least some of the plurality of battery cells; and at least one support member coupled to the sensing branch and configured to support the sensing branch.

## Description

### TECHNICAL FIELD

The present disclosure relates to a battery pack and a vehicle including the same and, more specifically, to a battery pack in which the rigidity of a sensing member is strengthened to improve energy density and assembly efficiency and to reduce failure rates, and a vehicle including the same.

This application is based on and claims priority from Korean Patent Application No. 10-2024-0076631, filed on June 12, 2024, with the Korean Intellectual Property Office, the disclosure of which is incorporated herein in its entirety by reference.

### BACKGROUND ART

Recently, the demand for portable electronic products such as laptops, video cameras, and mobile phones has rapidly increased, and the development of electric vehicles, energy storage batteries, robots, satellites, and the like has been accelerated, so in line with this, active researches on high-performance secondary batteries capable of being repeated charged and discharged are underway.

Currently commercialized secondary batteries include nickel-cadmium batteries, nickel-hydrogen batteries, nickel-zinc batteries, and lithium-ion secondary batteries. Among these, lithium-ion secondary batteries are in the spotlight for their advantages of flexible charging and discharging due to almost no memory effect, a very low self-discharge rate, and a high energy density, compared to nickel-based secondary batteries.

These lithium-ion secondary batteries generally use lithium-based oxides and carbon materials as positive and negative electrode active materials, respectively. In addition, the lithium secondary batteries includes an electrode assembly in which the positive and negative electrode plates coated with the positive and negative electrode active materials, respectively, are disposed with a separator therebetween, and an exterior case that stores the electrode assembly with an electrolyte in a sealing manner.

Meanwhile, lithium-ion secondary batteries may be classified, depending on the shape of a battery case, into pouch-type secondary batteries in which the electrode assembly is stored in a pouch of an aluminum laminate sheet and can-type secondary batteries in which the electrode assembly is stored in a metal can. In addition, can-type secondary batteries may be further classified into cylindrical batteries and prismatic batteries depending on the shape of the metal can. In order to provide high voltage and current, these lithium-ion secondary batteries are assembled into a dense structure by stacking multiple battery cells to overlap each other with or without cartridges, and then electrically connected into a battery module or battery pack.

These days, research and development is actively being conducted on battery packs configured as a single module or cell assembly with improved structural rigidity by densely stacking multiple cylindrical battery cells to stand, and a pack frame that surrounds them. In particular, the size of a single module or cell assembly is on the increase in order to increase energy capacity.

A sensing member that senses voltage or temperature of multiple battery cells may be connected to such a single module or cell assembly. The sensing member may be provided in a thin form to improve the energy density of the battery pack. Since the sensing member is provided in such a thin form, the sensing member may be deformed or bendy in the process of connecting the sensing member to a single module or cell assembly, which reduces the assembly efficiency of the battery pack and increases the failure rate. Therefore, the development of a battery pack capable of improving energy density while improving assembly efficiency and reducing the failure rate is urgently required.

### DISCLOSURE

### Technical Problem

The present disclosure is designed to solve the problems of the related art, and therefore the present disclosure is directed to providing a battery pack with improved energy density and a vehicle including the same.

In addition, the present disclosure is to provide a battery pack with improved assembly efficiency and a vehicle including the same.

In addition, the present disclosure is to provide a battery pack with reduced failure rates and a vehicle including the same.

In addition, the present disclosure is to provide a miniaturized battery pack and a vehicle including the same.

In addition, the present disclosure is to provide a lightweight battery pack and a vehicle including the same.

In addition, the present disclosure is to provide a battery pack with improved welding efficiency and a vehicle including the same.

In addition, the present disclosure is to provide a battery pack with simplified assembly process and a vehicle including the same.

The technical problems that the present disclosure seeks to solve are not limited to the above-mentioned problems, and other problems not mentioned above will be clearly understood by those skilled in the art from the description of the invention described below.

### Technical Solution

In one aspect of the present disclosure, there is provided a battery pack including: a plurality of battery cells; a bus-bar assembly connected to the battery cells; and at least one sensing assembly connected to the bus-bar assembly, wherein the sensing assembly may include: a sensing member including at least one sensing branch configured to sense at least some of the plurality of battery cells; and at least one support member coupled to the sensing branch and configured to support the sensing branch.

The sensing assembly and the bus-bar assembly may be configured as an integrated assembly.

The sensing member may be a flexible printed circuit board.

The support member may include an insulating material having rigidity.

The support member and the sensing branch may be configured in shapes corresponding to each other.

The support member may be manufactured by injection molding.

The support member and the sensing branch may be bonded to each other.

The sensing branch may be formed to extend along one direction, and the support member may be formed to extend along a longitudinal direction of the sensing branch.

The support member may be disposed on the opposite side of the bus-bar assembly with respect to the sensing branch.

The sensing branch may include a first perimeter configured to expose an electrode of the battery cell to the outside and surround the electrode of the battery cell, and the support member may include a second perimeter having a shape corresponding to the first perimeter.

The bus-bar assembly may include a sub-bus-bar unit connected to the electrode of the battery cell, and the sensing branch and the sub-bus-bar unit may be welded to each other at a first weld. The sub-bus-bar unit and the electrode of the battery cell may be welded to each other at a second weld, and the first perimeter and the second perimeter may not cover the first weld and the second weld.

The sensing branch may include a metal plate configured to guide welding connection with the sub-bus-bar unit, and the support member may support the metal plate.

The metal plate may be configured as a nickel plate.

The sensing branch may include: a plurality of the first perimeters arranged in a row; and at least one first bridge configured to connect the plurality of the first perimeters, and the support member may include: a plurality of the second perimeters corresponding to the plurality of first perimeters; and at least one second bridge corresponding to the at least one first bridge.

The width of the second bridge may be formed to be greater than the width of the first bridge.

The bus-bar assembly
may be coupled to the battery cell and the sensing assembly, and
may be pre-coupled to the sensing assembly and then provided before being coupled to the battery cell.

The bus-bar assembly may include a sub-bus-bar unit including a plurality of connection bus-bars connected to the electrodes of the battery cell, and the sensing assembly may be coupled to the plurality of connection bus-bars.

In another aspect of the disclosure, there is provided a vehicle including at least one battery pack according to the present disclosure.

### Advantageous Effects

According to the present disclosure, it is possible to provide a battery pack with improved energy density by a sensing assembly including a support member, and a vehicle including the same.

In addition, it is possible to provide a battery pack with improved assembly efficiency by a sensing assembly including a support member, and a vehicle including the same.

In addition, it is possible to provide a battery pack with reduced failure rates by a sensing assembly including a support member, and a vehicle including the same.

In addition, it is possible to provide a miniaturized battery pack by a sensing assembly including a support member, and a vehicle including the same.

In addition, it is possible to provide a lightweight battery pack by a sensing assembly including a support member, and a vehicle including the same.

In addition, it is possible to provide a battery pack with improved welding efficiency by a sensing assembly including a support member, and a vehicle including the same.

In addition, it is possible to provide a battery pack with simplified assembly process by a bus-bar assembly and a sensing assembly that are pre-coupled and provided, and a vehicle including the same.

The effects obtainable from the present disclosure are not limited to the above-mentioned effects, and other effects not mentioned above will be clearly understood by those skilled in the art from the description of the invention described below.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a perspective view illustrating a battery pack according to an embodiment of the present disclosure.
FIG. 2 is a perspective view illustrating a battery pack in which a bus-bar assembly and a sensing assembly are connected to a cell array structure according to an embodiment of the present disclosure.
FIG. 3 is an exploded perspective view of the cell array structure, the bus-bar assembly, and the sensing assembly in FIG. 2.
FIG. 4 is an exploded perspective view of a sensing assembly in a battery pack according to an embodiment of the present disclosure.
FIG. 5 is a perspective view illustrating a battery pack in which a sensing assembly and a bus-bar assembly are configured as an integrated assembly according to another embodiment of the present disclosure.
FIG. 6 is an exploded perspective view illustrating a cell array structure of a battery pack according to an embodiment of the present disclosure.
FIG. 7 is an exploded perspective view illustrating the bus-bar assembly of a battery pack according to an embodiment of the present disclosure.
FIG. 8 is a plan view illustrating a battery pack in which a bus-bar assembly and a sensing assembly are connected to a cell array structure according to an embodiment of the present disclosure.
FIG. 9 is an enlarged plan view of area A in FIG. 8.
FIG. 10 is an enlarged plan view illustrating a sensing branch in a battery pack according to an embodiment of the present disclosure.
FIG. 11 is an enlarged plan view illustrating a support member in a battery pack according to an embodiment of the present disclosure.
FIG. 12 is an enlarged plan view illustrating a support member in a battery pack according to a modification of an embodiment of the present disclosure.
FIG. 13 is an enlarged plan view of area B in FIG. 9.
FIG. 14 is a plan view illustrating a metal plate added to FIG. 13.
FIG. 15 is an enlarged plan view illustrating a portion of a sensing assembly according to an embodiment of the present disclosure.
FIG. 16 is a drawing illustrating a vehicle according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

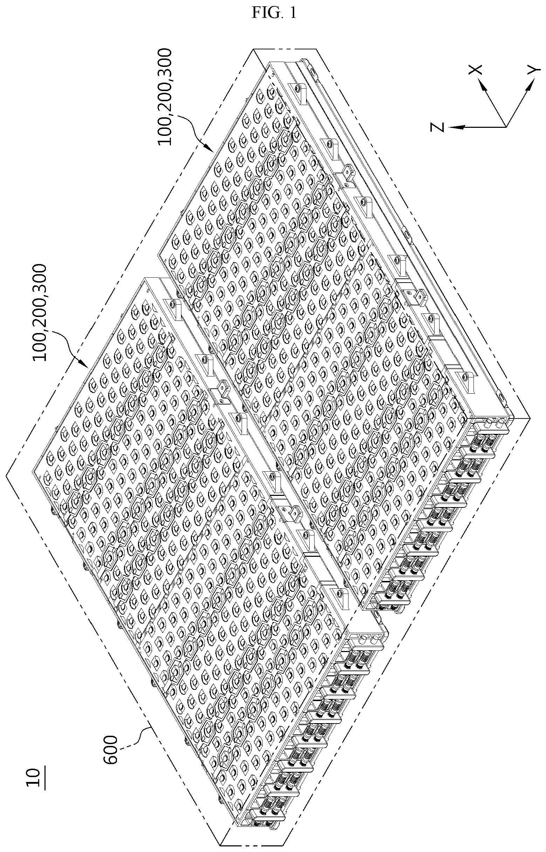

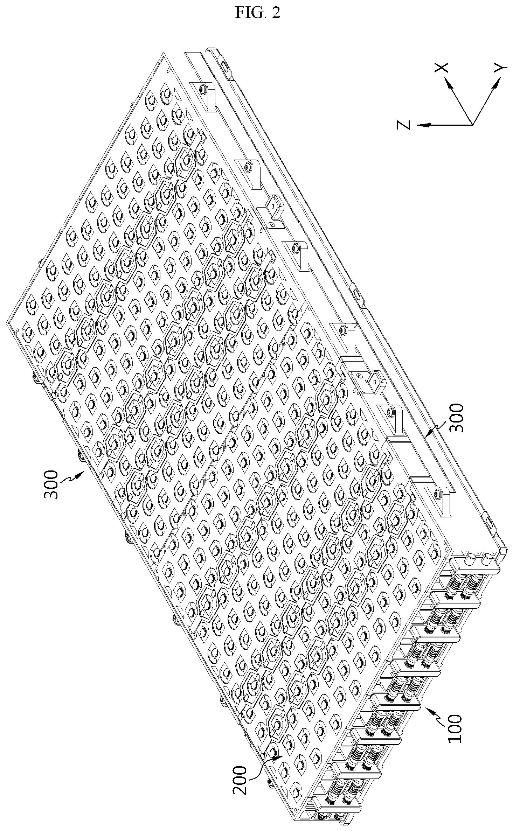

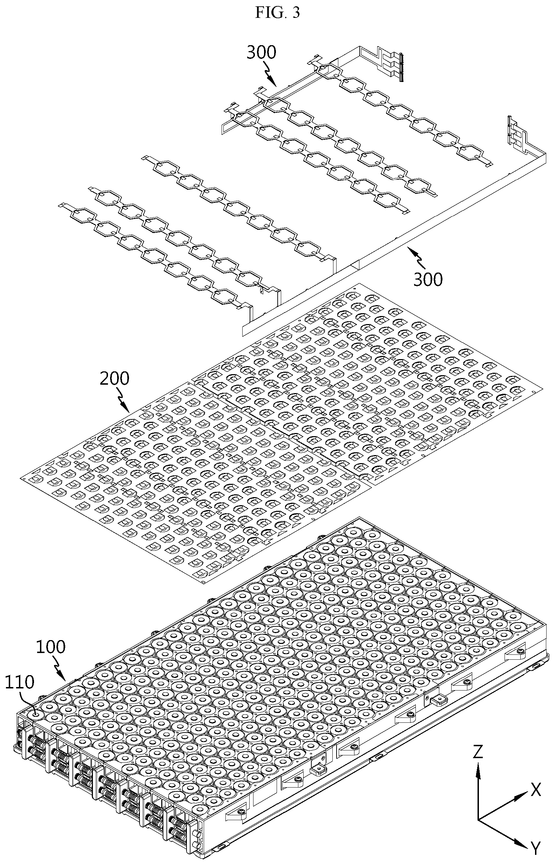

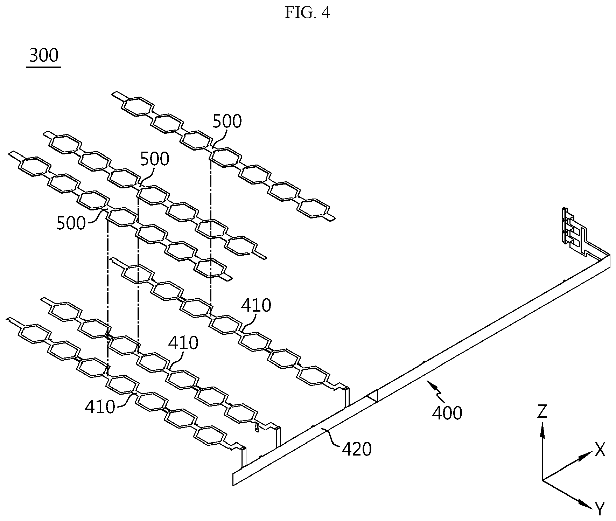

FIG. 1 is a perspective view illustrating a battery pack according to an embodiment of the present disclosure, FIG. 2 is a perspective view illustrating a battery pack in which a bus-bar assembly and a sensing assembly are connected to a cell array structure according to an embodiment of the present disclosure, FIG. 3 is an exploded perspective view of the cell array structure, the bus-bar assembly, and the sensing assembly in FIG. 2, and FIG. 4 is an exploded perspective view of a sensing assembly in a battery pack according to an embodiment of the present disclosure.

Hereinafter, a battery pack 10 according to an embodiment of the present disclosure will be described in detail with reference to FIGS. 1 to 4. The battery pack 10 according to an embodiment of the present disclosure may include a plurality of battery cells 110, a bus-bar assembly 200, and a sensing assembly 300.

The battery pack 10 may be configured in a three-dimensional structure having a predetermined width, length, and height in the X, Y, and Z directions, respectively. The battery pack 10 may have a structure suitable for mounting on a vehicle body.

The battery cell 110 is a secondary battery, and may be configured as a cylindrical secondary battery, a pouch-type secondary battery, or a prismatic secondary battery. Hereinafter, although the plurality of battery cells 110 will be described as being configured as cylindrical secondary batteries in the present embodiment, the disclosure is not limited thereto, and it is obvious that a pouch-type secondary battery or a prismatic secondary battery may be applied to the battery cell 110.

The plurality of battery cells 110 may configure a cell array structure 100. The cell array structure 100 may be understood as a single assembly or structure in which the plurality of battery cells 110 are arranged as follows. For example, the plurality of battery cells 110 may be arranged in a horizontal direction parallel to the X-Y plane and perpendicular to the Z direction in the cell array structure 100. The cell array structure 100 may have a predetermined length, width, and height in the X direction, Y direction, and Z direction, respectively. The battery pack 10 including the cell array structure 100 may be provided as a so-called cell-to-pack structure without including a separate module case, thereby increasing space efficiency and improving energy density. The cell array structure 100 may be configured to have a large area by increasing the number of battery cells 110 arranged.

The bus-bar assembly 200 may be connected to the battery cell 110. The bus-bar assembly 200 may be connected to each of the plurality of battery cells 110. Here, the connection may be understood as an electrical connection and/or a physical connection. The bus-bar assembly 200 may be disposed on one side of the battery cell 110. For example, the bus-bar assembly 200 may be disposed on the top (in the +Z direction) of the battery cell 110. The bus-bar assembly 200 may be disposed at one side of the cell array structure 100. For example, the bus-bar assembly 200 may be disposed on the top (in the +Z direction) of the cell array structure 100.

The sensing assembly 300 may be connected to the bus-bar assembly 200. Here, the connection may be understood as an electrical connection and/or a physical connection. The sensing assembly 300 may be disposed on one side of the bus-bar assembly 200. For example, the sensing assembly 300 may be disposed on the upper side (in the +Z direction) of the bus-bar assembly 200. The battery pack 10 according to the present disclosure may include at least one sensing assembly 300. The battery pack 10 according to the present disclosure may include a plurality of sensing assemblies 300.

The sensing assembly 300 may include a sensing member 400 and a support member 500. The sensing member 400 may be configured to sense at least some of the plurality of battery cells 110. The sensing member 400 may sense the voltage or temperature of the battery cell 110. Here, sensing may be LV (low-voltage) sensing for detecting the voltage or temperature of the battery cell 110. Sensing information such as voltage information or temperature information of the battery cell 110 obtained by LV sensing of the sensing member 400 may be transmitted to a BMS (Battery Management System), which will be described later.

The sensing member 400 may include at least one sensing branch 410. The sensing branch 410 may be configured to sense at least some of the plurality of battery cells 110. The sensing branch 410 may sense the voltage or temperature of the battery cell 110, and the sensing may be LV sensing.

Meanwhile, one sensing member 400 may include a plurality of sensing branches 410. In this case, the battery cell 110 sensed by one of the plurality of sensing branches 410 may not overlap the battery cell 110 sensed by another sensing branch 410. The sensing branch 410 may be configured to be thin. In the case where the sensing branch 410 is configured to be thin, the energy density of the battery pack 10 may be improved.

The support member 500 may be coupled to the sensing branch 410. Here, the coupling may be understood as a physical coupling. The support member 500 may be fixed to the sensing branch 410. The support member 500 may support the sensing branch 410. The support member 500 may be coupled to the sensing branch 410 to strengthen the rigidity of the sensing branch 410. The sensing assembly 300 may include at least one support member 500. The support member 500 may be provided to correspond to the sensing branch 410 of the sensing member 400, and the support member 500 may be coupled to the sensing branch 410 so as to correspond to each sensing branch 410.

In the battery pack 10 including the plurality of battery cells 110, the bus-bar assembly 200, and the sensing member 400, a process of assembling the battery pack 10 may include a process of connecting the plurality of battery cells 110 and the bus-bar assembly 200, and a process of connecting the bus-bar assembly 200 and the sensing member 400. The process of connecting the bus-bar assembly 200 and the sensing member 400 may include a process of loading and aligning the sensing member 400 onto the bus-bar assembly 200, and a process of connecting the loaded and aligned sensing member 400 to the bus-bar assembly 200. In a conventional battery pack, since the rigidity of the sensing member is insufficient, the sensing member may be deformed or bendy during the process of loading and aligning the sensing member onto the bus-bar assembly, thereby degrading the assembly efficiency of the battery pack and increasing the failure rate.

In the battery pack 10 according to the present disclosure, the support member 500 may be coupled to the sensing member 400 and provided as the sensing assembly 300. Accordingly, the assembly process of the battery pack 10 according to the present disclosure may include a process of connecting the plurality of battery cells 110 and the bus-bar assembly 200, and a process of connecting the bus-bar assembly 200 and the sensing assembly 300. The support member 500 may reinforce the rigidity of the sensing member 400. Accordingly, the sensing member 400 may be prevented from being deformed or becoming bendy when loading and aligning the sensing member 400 during the process of connecting the bus-bar assembly 200 and the sensing assembly 300 in the assembly process of the battery pack 10. As a result, the battery pack 10 according to the present disclosure has the effect of significantly improving the assembly efficiency and reducing the failure rate, compared to the conventional battery pack. In addition, in the battery pack 10 according to the present disclosure, the sensing member 400 may be produced to be thinner because the support member 500 is able to reinforce the rigidity of the sensing member 400, thereby improving the energy density of the battery pack 10.

Meanwhile, the sensing assembly 300 may be disposed so that the bus-bar assembly 200 is disposed between the plurality of battery cells 110 or the cell array structure 100 and the same. For example, the plurality of battery cells 110 or the cell array structure 100 may be disposed on the lower side (in the -Z direction) of the bus-bar assembly 200, and the sensing assembly 300 may be disposed on the upper side (in the +Z direction) of the bus-bar assembly 200.

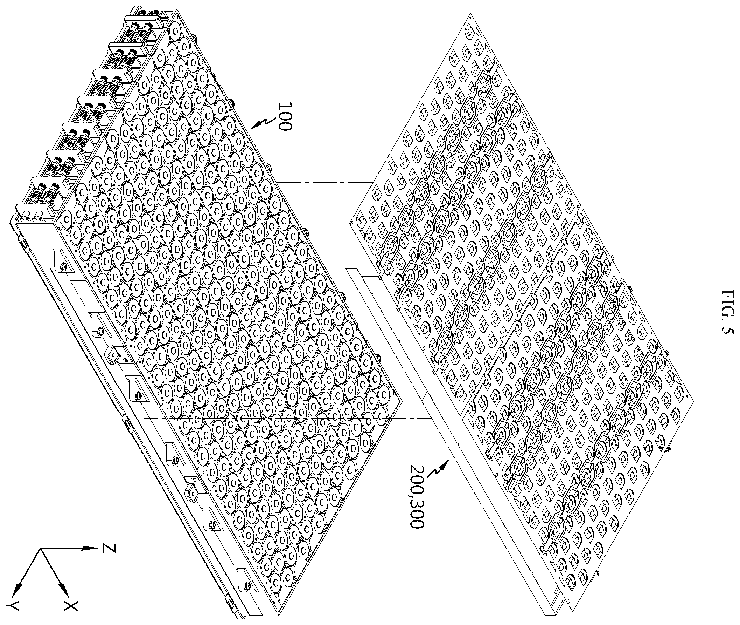

FIG. 5 is a perspective view illustrating a battery pack in which a sensing assembly and a bus-bar assembly are configured as an integrated assembly according to another embodiment of the present disclosure.

Referring to FIG. 5, in a battery pack 10 according to another embodiment of the present disclosure, a sensing assembly 300 and a bus-bar assembly 200 may be configured as an integrated assembly. Specifically, the sensing assembly 300 and the bus-bar assembly 200 may be configured at once in an integrated assembly form.

Accordingly, the assembly of the battery pack 10 according to another embodiment of the present disclosure may be performed by a process of connecting the plurality of battery cells 110 and the integrated assembly of the sensing assembly 300 and bus-bar assembly 200.

As described above, the assembly process of the battery pack 10 according to an embodiment of the present disclosure may include a process of connecting the plurality of battery cells 110 and the bus-bar assembly 200, and a process of connecting the bus-bar assembly 200 and the sensing assembly 300. However, the battery pack 10 according to another embodiment of the present disclosure may be assembled by a single process of connecting the plurality of battery cells 110 to the integrated assembly of the sensing assembly 300 and bus-bar assembly 200. As a result, the assembly efficiency of the battery pack 10 may be further improved.

In addition, the support member 500 of the sensing assembly 300 may also reinforce the rigidity of the bus-bar assembly 200. Therefore, when the bus-bar assembly 200 is connected to the plurality of battery cells 110, the support member 500 may prevent the bus-bar assembly 200 from being deformed or becoming bendy. Therefore, the assembly efficiency of the battery pack 10 may be further improved, and the defect rate may be further reduced.

Hereinafter, a battery pack according to an embodiment of the present disclosure will be described in more detail with reference to FIGS. 1 to 4.

The sensing member 400 may be a flexible printed circuit board (FPCB). The flexible printed circuit board may be understood as a printed circuit board (PCB) that is flexible using a polymer material.

When the sensing member 400 is applied as a flexible circuit board, there may be advantages in which the sensing member 400 can be manufactured to be thin in various shapes and structures, and in which the sensing member 400 can be miniaturized and made lightweight. However, as the sensing member 400 becomes flexible, there may be a disadvantage in which the rigidity of the sensing member 400 becomes lower.

The battery pack 10 according to the present disclosure may have a support member 500 coupled to the sensing member 400, which is a flexible printed circuit board. Therefore, the battery pack 10 according to the present disclosure may resolve all the disadvantages of the conventional battery pack described above while having all the advantages of the flexible printed circuit board as described above.

The support member 500 may include an insulating material having rigidity. As a result, the support member 500 may secure insulation properties while having rigidity. For example, the support member 500 may include FR4 (Fiberglass Reinforced Epoxy Laminate) material. FR4 is a type of epoxy resin laminate reinforced with glass fibers, and has the advantages of excellent electrical insulation properties, excellent mechanical, chemical, and thermal stability, and easy molding and processing.

In the case where the support member 500 includes an insulating material having rigidity, the support member 500 may firmly support the sensing member 400, and effectively prevent electricity from being transmitted to the outside through the sensing member 400.

The support member 500 and the sensing branch 410 may be configured in the shapes corresponding to each other. For example, the support member 500 and the sensing branch 410 may be configured to have the same shape at least in part. For example, a second perimeter 510 of the support member 500 and a first perimeter 411 of the sensing branch 410, which will be described below, may be configured to have the same shape at least in part. The support member 500 and the sensing branch 410 configured to have corresponding shapes may be disposed to overlap each other. For example, when viewed in the up-down direction (Z-axis direction), the support member 500 and the sensing branch 410 may be disposed to overlap each other.

As described above, in the case where the support member 500 and the sensing branch 410 are configured to have corresponding shapes, there is an advantage in which the support member 500 may strongly support the sensing branch 410, and in which the support member 500 may be miniaturized and made lightweight.

The support member 500 may be manufactured by injection molding. Specifically, the support member 500 may be manufactured by being molded through an injection molding process. The injection molding process has the advantage of manufacturing a product of a complex and precise shape with a very small molding error and manufacturing a product quickly at a low cost.

Therefore, when the support member 500 is manufactured through injection molding, even a support member 500 of a complex and precise shape may also be manufactured with a very small molding error, and the support member 500 may be manufactured quickly at a low cost, so that the manufacturing efficiency of the support member 500 may be improved.

The support member 500 and the sensing branch 410 may be bonded to each other. Specifically, the support member 500 and the sensing branch 410 may be bonded to each other while being in contact with each other, and fixed to each other. In order to bond the support member 500 and the sensing branch 410 to each other, a structural adhesive may be applied between the support member 500 and the sensing branch 410.

In the case where the support member 500 and the sensing branch 410 are bonded to each other, the support member 500 and the sensing branch 410 may be bonded without a separate part, so that the battery pack 10 may be made lighter and the productivity of the battery pack 10 may be improved. In addition, since the support member 500 may be firmly fixed and bonded to the sensing branch 410, the support member 500 may support the sensing branch 410 more stably. In addition, even if the support member 500 and the sensing branch 410 are configured to include different materials from each other, they may be effectively bonded to each other.

The sensing branch 410 may be formed to extend in one direction. The sensing branch 410 extending one direction may be provided to cross at least some of the plurality of battery cells 110 of the cell array structure 100. For example, the sensing branch 410 may be formed to extend along the width direction (Y-axis direction) of the cell array structure 100 and cross the plurality of corresponding battery cells 110 on the upper side (in the +Z-direction) of the cell array structure 100. The support member 500 may be formed to extend along the longitudinal direction of the sensing branch 410. For example, when the sensing branch 410 is formed to extend along the width direction (Y-axis direction) of the cell array structure 100, the support member 500 may also be formed to extend along the width direction (Y-axis direction) of the cell array structure 100.

In the case where the sensing branch 410 is formed to extend along one direction, the rigidity of the sensing branch 410 may be degraded, so that the sensing branch 410 may be easily deformed or bendy. However, if the support member 500 is formed to extend along the longitudinal direction of the sensing branch 410, the support member 500 may effectively support the sensing branch 410 whose rigidity becomes low, thereby preventing the support member 500 from being easily deformed or becoming bendy.

The support member 500 may be disposed on the opposite side of the bus-bar assembly 200 with respect to the sensing branch 410. Specifically, the support member 500 may be disposed so that the sensing branch 410 is located between the bus-bar assembly 200 and the same. For example, the bus-bar assembly 200 may be disposed on the lower side (in the -Z direction) of the sensing branch 410, and the support member 500 may be disposed on the upper side (in the +Z direction) of the sensing branch 410.

As described above, if the support member 500 is disposed on the opposite side of the bus-bar assembly 200 with respect to the sensing branch 410, the sensing branch 410 may be more directly connected to the bus-bar assembly 200, and the connection between the sensing branch 410 and the bus-bar assembly 200 may be prevented from being interfered with the support member 500.

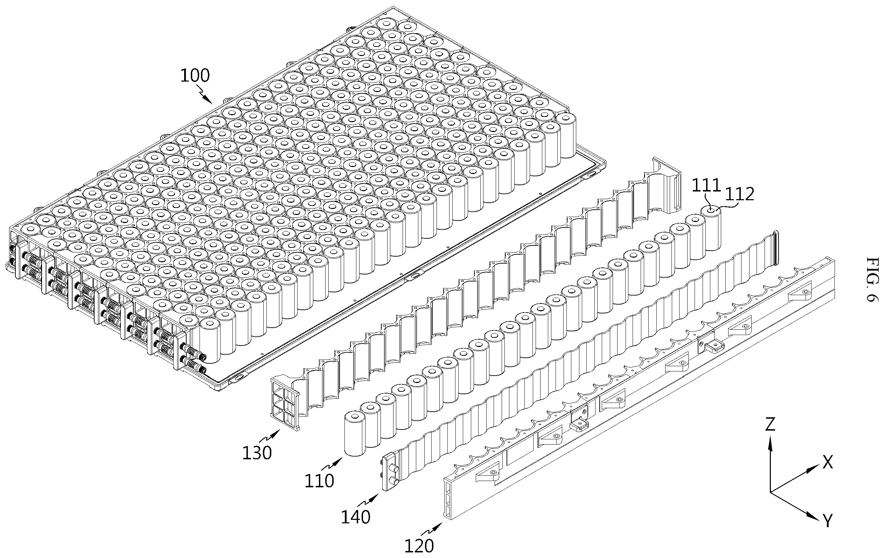

FIG. 6 is an exploded perspective view illustrating a cell array structure of a battery pack according to an embodiment of the present disclosure.

Hereinafter, the cell array structure 100 will be described in more detail with reference to FIG. 6. The battery cell 110 of the cell array structure 100 may include electrodes 111 and 112. The electrodes 111 and 112 may include a positive electrode 111 and a negative electrode 112. The electrodes 111 and 112 may be disposed on the upper side (in the +Z direction) of the battery cell 110. The positive electrode 111 may be disposed on the inner side of the electrodes 111 and 112, and the negative electrode 112 may be disposed along the outer periphery of the positive electrode 111.

The plurality of battery cells 110 may be disposed in rows (hereinafter, referred to as a battery cell 110 row) along one direction. For example, the battery cell 110 row may be disposed to form a row along the longitudinal direction (X-axis direction) of the cell array structure 100.

The cell array structure 100 may include side frames 120 and 130. The side frames 120 and 130 may be configured to store and support the plurality of battery cells 110.

The side frames 120 and 130 may include a side wall 120 and a side structure 130. The side wall 120 may be disposed at the outermost side of the side frames 120 and 130 and may store and support the plurality of battery cells 110 on one side. The side wall 120 may extend along the longitudinal direction of the battery cell 110 row. For example, the side wall 120 may extend along the longitudinal direction (X-axis direction) of the cell array structure 100. The side structure 130 may be positioned at a location other than the outermost sides of the side frames 120 and 130, and may store and support the plurality of battery cells 110 on both sides. The side structure 130 may extend along the longitudinal direction of the battery cell 110 row. For example, the side structure 130 may extend along the longitudinal direction (X-axis direction) of the cell array structure 100.

Meanwhile, as described above, the sensing branch 410 may be formed to extend along one direction, and the sensing branch 410 may be formed to extend in a direction intersecting the longitudinal direction of the side wall 120 and the side structure 130. In addition, the sensing branch 410 may be formed to extend in a direction intersecting the battery cell 110 row.

The sensing member 400 may include a connecting portion 420. At least one sensing branch 410 may be connected to the connecting portion 420. For example, a plurality of sensing branches 410 may be connected to one connecting portion 420. Sensing information of the battery cells 110 obtained from the respective sensing branches 410 may be transmitted to the connecting portion 420 and integrated.

The connecting portion 420 may be formed to extend in a direction intersecting the sensing branch 410. For example, in the case where the sensing branch 410 is formed to extend in the width direction (Y-axis direction) of the cell array structure 100, the connecting portion 420 may be formed to extend in the longitudinal direction (X-direction) of the cell array structure 100. The connecting portion 420 may be disposed at the outermost portion of the cell array structure 100. For example, the connecting portion 420 may be disposed on the side wall 120.

The sensing member 400 may further include a connector 430. The connector 430 may be transmitted to the BMS described below. The connector 430 may be connected to the connecting portion 420.

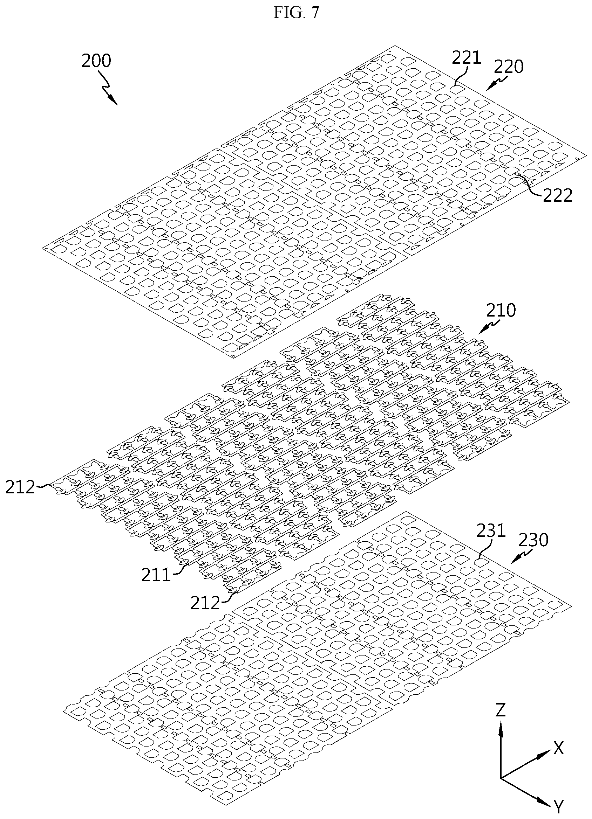

FIG. 7 is an exploded perspective view illustrating the bus-bar assembly of a battery pack according to an embodiment of the present disclosure.

Hereinafter, the bus-bar assembly 200 will be described in detail with reference to FIG. 7. The bus-bar assembly 200 may include a sub-bus-bar unit 210.

The sub-bus-bar unit 210 may be connected to the electrodes 111 and 112 of each of the plurality of battery cells 110. The sub-bus-bar unit 210 may include a two-way connection bus-bar 211 and a one-way connection bus-bar 212.

The two-way connection bus-bar 211 may be connected to the electrodes 111 and 112 of the battery cell 110 on both sides. The two-way connection bus-bar 211 may be formed to extend overall in the longitudinal direction (X-axis direction) of the cell array structure 100, but may be connected to the electrodes 111 and 112 of the battery cell 110 on both sides (in the -Y direction and +Y direction) in the width direction of the cell array structure 100.

The one-way connection bus-bar 212 may be connected to the electrodes 111 and 112 of the battery cell 110 on one side. The one-way connection bus-bar 212 may be formed to extend in the longitudinal direction (X-axis direction) of the cell array structure, but may be connected to the electrode 111 and 112 of the battery cell 110 at one side of the cell array structure 100 in the width direction (-Y direction or +Y direction). Each of the two-way connection bus-bar and the one-way connection bus-bar 212 may include a positive-electrode connection portion 213 described later and/or a negative-electrode connection portion 214 to be described later.

The bus-bar assembly 200 may include bus-bar covers 220 and 230. The bus-bar covers 220 and 230 may be configured to cover the upper side (in +Z direction) of the plurality of battery cells 110. The bus-bar covers 220 and 230 may be configured as an insulating material.

The bus-bar covers 220 and 230 may be provided to be coupled to each other with the sub-bus-bar unit 210 interposed therebetween. Specifically, the bus-bar covers 220 and 230 may include a first bus-bar cover 220 and a second bus-bar cover 230. The first bus-bar cover 220 may cover the upper side (in the Z direction) of the sub-bus-bar unit 210. The second bus-bar cover 230 may cover the lower side (in the -Z direction) of the sub-bus-bar unit 210.

Guide openings 221 and 231 may be formed in the bus-bar covers 220 and 230. The guide openings 221 and 231 may expose the connection portion between the electrodes 111 and 112 of the battery cell 110 and the sub-bus-bar unit 210 to guide the connection between the electrodes 111 and 112 of the battery cell 110 and the sub-bus-bar unit 210. The guide openings 221 and 231 may include a first guide opening 221 and a second guide opening 231. The first guide opening 221 may be formed in the first bus-bar cover 220, and the second guide opening 231 may be formed in the second bus-bar cover 230. The first guide opening 221 and the second guide opening 231 may be formed in shapes corresponding to each other.

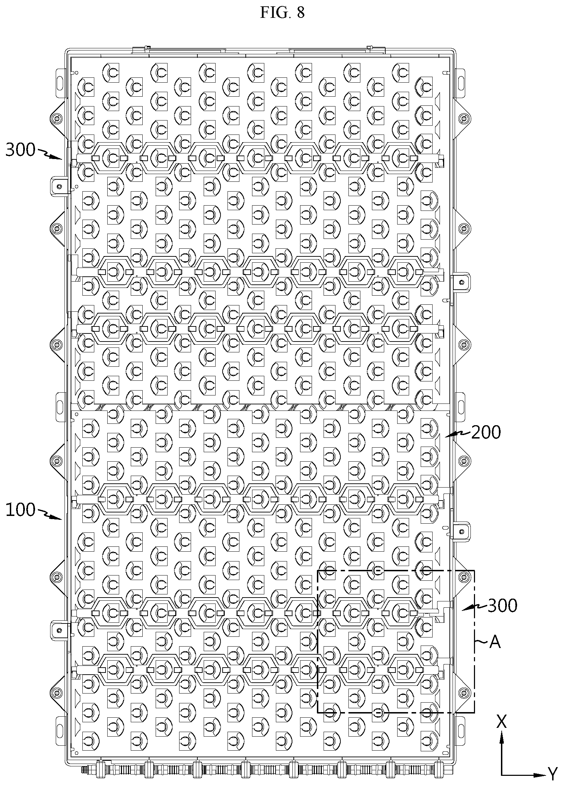

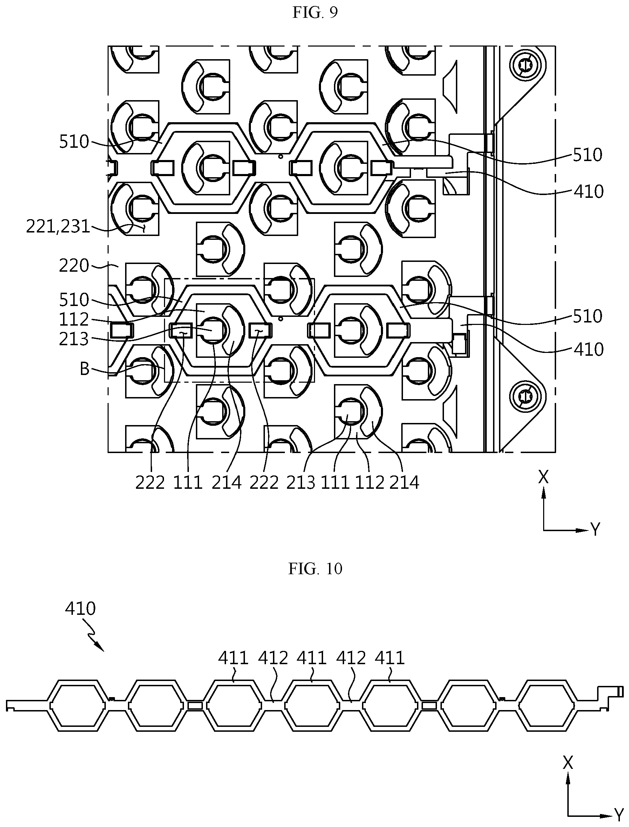

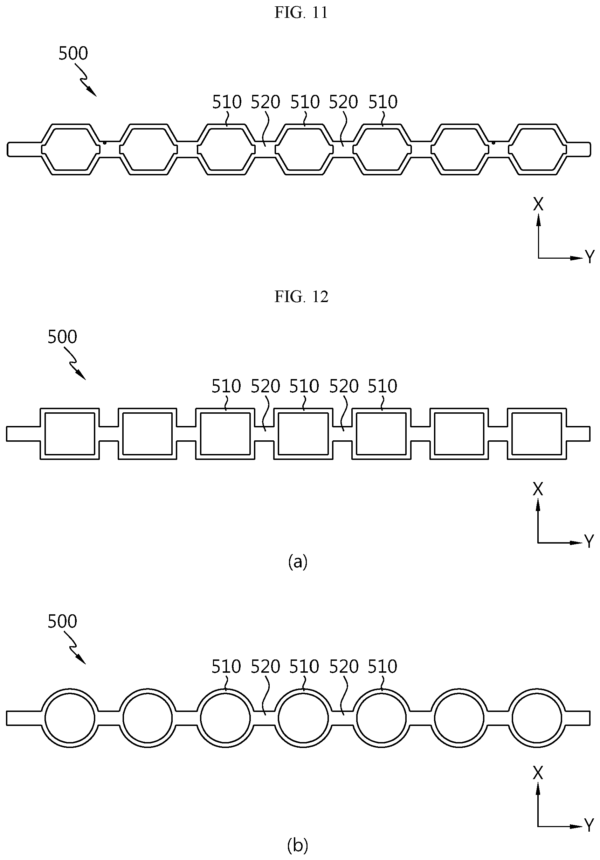

FIG. 8 is a plan view illustrating a battery pack in which a bus-bar assembly and a sensing assembly are connected to a cell array structure according to an embodiment of the present disclosure, FIG. 9 is an enlarged plan view of area A in FIG. 8, FIG. 10 is an enlarged plan view illustrating a sensing branch in a battery pack according to an embodiment of the present disclosure, and FIG. 11 is an enlarged plan view illustrating a support member in a battery pack according to an embodiment of the present disclosure.

Hereinafter, the sensing assembly 300 according to an embodiment of the present disclosure will be described in more detail with reference to FIGS. 8 to 11.

The sensing branch 410 may include a first perimeter 411. The first perimeter 411 may expose the electrodes 111 and 112 of the battery cell 110 to the outside. The first perimeter 411 may have an opening at least in part so that the electrodes 111 and 112 of the battery cell 110 may be exposed to the outside. For example, the central portion of the first perimeter 411 may be formed to have an opening in the up-down direction (Z-axis direction). The first perimeter 411 may be formed at positions corresponding to the guide openings 221 and 231 of the bus-bar covers 220 and 230. The electrodes 111 and 112 of the battery cell 110 may be exposed to the outside through the first perimeters 411 and the guide openings 221 and 231.

The first perimeter 411 may surround the electrodes 111 and 112 of the battery cell 110. Specifically, the first perimeter 411 may surround the electrodes 111 and 112 of the battery cell 110 so that the electrodes 111 and 112 of the battery cell 110 may be exposed to the outside. The first perimeter 411 may be formed to surround the guide openings 221 and 231 of the bus-bar covers 220 and 230. The first perimeter 411 may be formed larger than the guide openings 221 and 231 of the bus-bar covers 220 and 230. The sub-bus-bar unit 210 may include a positive-electrode connection portion 213 and a negative-electrode connection portion 214 connected to the positive electrode 111 and the negative electrode 112 of the battery cell 110. The positive-electrode connection portion 213 and the negative-electrode connection portion 214 connected to the electrodes 111 and 112 of the battery cell 110 may be exposed through the guide openings 221 and 231. The guide openings 221 and 231 may be exposed through the first perimeter 411. Therefore, the positive-electrode connection portion 213 and the negative-electrode connection portion 214 connected to the electrodes 111 and 112 of the battery cell 110 may be exposed through the guide openings 221 and 231 and the first perimeter 411.

The support member 500 may include a second perimeter 510. The second perimeter 510 may be configured in a shape corresponding to the first perimeter 411. For example, the second perimeter 510 may be configured to have the same shape as the first perimeter 411 at least in part. For example, the inner perimeter of the second perimeter 510, excluding some parts, may be configured to have the same shape as the inner perimeter of the first perimeter 411. For example, the outer perimeter of the second perimeter 510 may be configured to have the same shape as the outer perimeter of the first perimeter 411. The second perimeter 510, like the first perimeter 411, may surround the electrodes 111 and 112 of the battery cell 110, and may surround the electrodes 111 and 112 of the battery cell 110 so that the electrodes 111 and 112 of the battery cell 110 may be exposed to the outside.

As described above, in the case where the sensing branch 410 includes the first perimeter 411 and where the support member 500 includes the second perimeter 510, the electrodes 111 and 112 of the battery cell 110 may be effectively exposed. In addition, the stress applied to the sensing branch 410 may be dispersed, and the support member 500 may support the sensing branch 410 over a larger area, so that the rigidity of the sensing member 400 may be further reinforced.

FIG. 12 is an enlarged plan view illustrating a support member in a battery pack according to a modification of an embodiment of the present disclosure.

Hereinafter, a battery pack 10 according to a modification of an embodiment of the present disclosure will be described with reference to FIG. 12. The battery pack 10 according to a modification of an embodiment of the present disclosure may include a first perimeter 411 of the sensing branch 410 and a second perimeter 510 of the support member 500, which are formed in a polygonal or circular shape.

For example, the second perimeter 510 may be formed in a hexagonal shape, and in this case, the rigidity of the support member 500 may be further increased (see FIG. 11). For example, the second perimeter 510 may be formed in a square shape, as shown in FIG. 12(a). However, the second perimeter 510 is not limited to the above shapes, and may be formed in a polygonal shape other than the hexagon or square. In addition, the second perimeter 510 may be formed in a circular shape, as shown in FIG. 12(b). In addition, although not shown in the drawing, some portions of the second perimeter 510 may be formed in a polygonal shape and the remaining portions may be configured in a circular shape.

The first perimeter 411 may be formed in a shape corresponding to the second perimeter 510. Accordingly, although only the second perimeter 510 is shown in FIG. 12, in the battery pack 10 according to a modification of an embodiment of the present disclosure, the shape of the first perimeter 411 may be understood to correspond to the shape of the second perimeter 510.

As described above, in the case where the first perimeter 411 and the second perimeter 510 are formed in a polygonal or circular shape, the sensing member 400 and the support member 500 may be configured in various shapes, so there is an advantage in which the sensing member 400 and the support member 500 may be configured in a shape optimized for the structure of the cell array structure 100 or the bus-bar assembly 200.

Meanwhile, a plurality of first perimeters 411 and a plurality of second perimeters 510 may be provided, and the plurality of first perimeters 411 and second perimeters 510 may be connected to each other by a first bridge 412 and a second bridge 520, which will be described later.

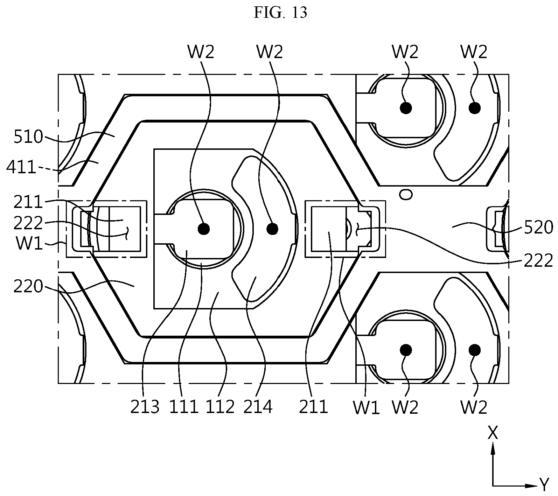

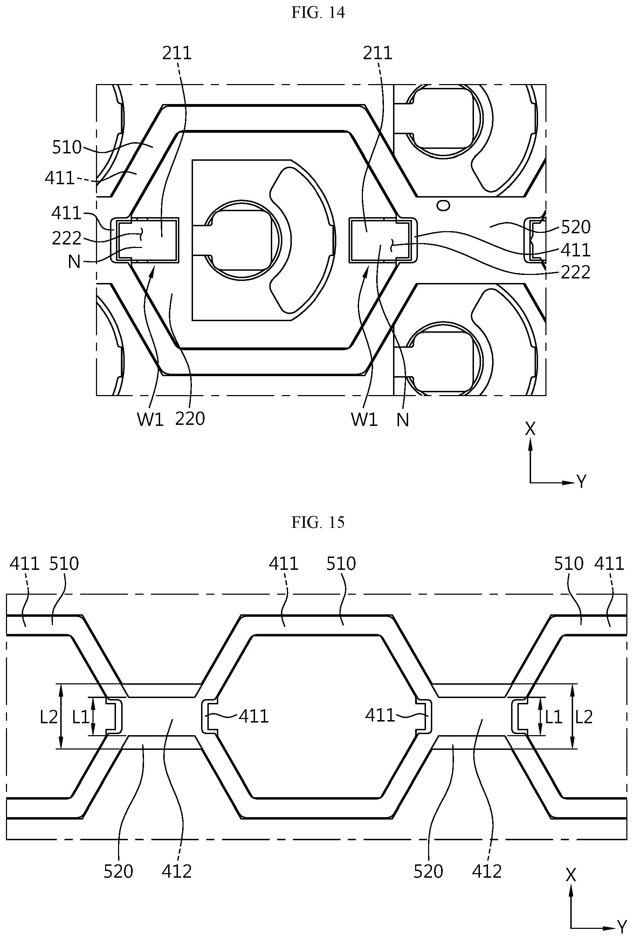

FIG. 13 is an enlarged plan view of area B in FIG. 9, and FIG. 14 is a plan view illustrating a metal plate added to FIG. 13.

Hereinafter, a first weld W1 and a second weld W2 of the battery pack 10 according to an embodiment of the present disclosure will be described in detail with reference to FIGS. 12 and 13.

Referring to FIG. 13, the sensing branch 410 and the sub-bus-bar unit 210 may be welded to each other at a first weld W1, and the sub-bus-bar unit 210 and the electrodes 111 and 112 of the battery cell 110 may be welded to each other at a second weld W2.

The first weld W1 may be understood as a portion where the sensing branch 410 and the sub-bus-bar unit 210 are welded to each other. Here, the welding may be laser welding. The first weld W1 may be formed at a position adjacent to the sensing branch 410. For example, the first weld W1 may be formed inside the first perimeter 411. In the case where the bus-bar assembly 200 includes the first bus-bar cover 220, the first bus-bar cover 220 may be disposed between the sensing branch 410 and the sub-bus-bar unit 210. A welding opening 222 may be formed in the first bus-bar cover 220 to expose the sub-bus-bar unit 210. As shown in the drawing, the first weld W1 may be understood as a region or part surrounding the welding opening 222.

The second weld W2 may be understood as a portion where the sub-bus-bar unit 210 and the electrodes 111 and 112 of the battery cell 110 are welded to each other. Here, the welding may be laser welding. The second weld W2 may be understood as a portion where the positive electrode 111 of the battery cell 110 and the positive-electrode connection portion 213 of the sub-bus-bar unit 210 are welded, and a portion where the negative electrode 112 of the battery cell 110 and the negative-electrode connection portion 214 of the sub-bus-bar unit 210 are welded. In the case where the bus-bar assembly 200 includes bus-bar covers 220 and 230, the second weld W2 may be formed inside the guide openings 221 and 231.

The first perimeter 411 and the second perimeter 510 may not cover the first weld W1 and the second weld W2. Specifically, the first perimeter 411 and the second perimeter 510 may not cover the first weld W1 and the second weld W2 when viewed from the direction in which the welding equipment for welding is introduced. For example, if the welding equipment is introduced along the up-down direction (Z-axis direction), the first perimeter 411 and the second perimeter 510 may not cover the first weld W1 and the second weld W2 when viewed along the up-down direction (Z-axis direction).

In addition, the first weld W1 may be formed in a part of the inner perimeter of the first perimeter 411 and the second perimeter 510. For example, in the case where the first perimeter 411 and the second perimeter 510 are formed in a polygonal shape, the first weld W1 may be formed in a region adjacent to the inner edges of the first perimeter 411 and the second perimeter 510. For example, in the case where the first perimeter 411 and the second perimeter 510 are formed in a circular shape, the first weld W1 may be formed in a region adjacent to the inner edges of the first perimeter 411 and second perimeter 510. In addition, the second weld W2 may be formed spaced apart from the inner perimeters of the first perimeter 411 and the second perimeter 510.

As described above, when the first perimeter 411 and the second perimeter 510 are configured so as not to cover the first weld W1 and the second weld W2, the first weld W1 and the second weld W2 are not interfered with the first perimeter 411 and the second perimeter 510 during the welding operation, thereby maximizing the efficiency of the welding operation. In addition, a relatively wide empty space may be formed around the first weld W1 and the second weld W2, so that the efficiency of the welding operation may be maximized.

Referring to FIG. 14, the sensing branch 410 may include a metal plate N. The metal plate N may guide the welding connection of the sensing branch 410 with the sub-bus-bar unit 210. The metal plate N may be disposed at the first weld W1. Accordingly, the sensing branch 410 and the sub-bus-bar unit 210 may be welded to each other by the metal plate N at the first weld W1. The metal plate N may be disposed on the welding opening 222. Accordingly, the sensing branch 410 and the sub-bus-bar unit 210 may be welded to each other by the metal plate N at the welding opening 222.

The metal plate N may be coupled to a part of the inner perimeter of the first perimeter 411. The metal plate N may be formed to extend from the first perimeter 411 to the sub-bus-bar unit 210. The metal plate N may be configured as a thin plate including a metal material.

The support member 500 may support the metal plate N. Specifically, the support member 500 may directly support the metal plate N, and in this case, the metal plate N may be configured to be directly coupled to the second perimeter 510.

Alternatively, the support member 500 may indirectly support the metal plate N, and in this case, the metal plate N may be configured to be coupled to the first perimeter 411, instead of being coupled to the second perimeter 510. In the case where the support member 500 indirectly supports the metal plate N, the support member 500 may indirectly support the metal plate N by supporting the first perimeter 411 to which the metal plate N is coupled.

Meanwhile, the support member 500 may be configured in a polygonal or circular shape as described above in order to effectively support the metal plate N, and in particular, in the case where the support member 500 is configured in a hexagonal shape, the metal plate N may be supported more effectively.

The support member 500 may support the metal plate N that may be deformed or bendy during welding, thereby firmly supporting the metal plate N. Accordingly, the workability and quality of welding may be maximized during welding.

The metal plate N may be configured as a nickel plate. The nickel plate may include a nickel (Ni) material. Nickel has excellent strength and corrosion resistance, and has excellent resistance to high-temperature cracking and cooling cracking, and thus has the advantage of being able to form a high-quality welding bead.

FIG. 15 is an enlarged plan view illustrating a portion of a sensing assembly according to an embodiment of the present disclosure.

Hereinafter, a sensing branch 410 and a support member 500 according to an embodiment of the present disclosure will be described in more detail with reference to FIGS. 10, 11, and 15.

The sensing branch 410 may include a plurality of first perimeters 411. The plurality of first perimeters 411 may be arranged in a row. For example, the plurality of first perimeters 411 may be arranged in a row along the width direction (Y-axis direction) of the cell array structure 100. The sensing branch 410 may include at least one first bridge 412. The first bridges 412 may connect the plurality of first perimeters 411. Specifically, the first bridge 412 may be disposed between two first perimeters 411 to connect the two first perimeters 411 to each other. The first bridge 412 may be formed integrally with the first perimeter 411.

The support member 500 may include the plurality of second perimeters 510 corresponding to the first perimeters 411. That is, the support member 500 may include a plurality of second perimeters 510 configured in a number, positions, and shapes corresponding to the number and shapes of the first perimeter 411.

The support member 500 may include at least one second bridge 520 corresponding to the first bridge 412. That is, the support member 500 may include at least one second bridge 520 configured in a number, positions, and shapes corresponding to the number and shapes of the first bridge 412. The second bridge 520 may connect the plurality of second perimeters 510. Specifically, the second bridge 520 may be disposed between two second perimeters 510 to connect the two second perimeters 510 to each other. The second bridge 520 may be formed integrally with the second perimeter 510.

As described above, in the case where the sensing branch 410 and the support member 500 include the first bridge 412 and the second bridge 520, the rigidity of the sensing member 400 may be maintained while miniaturizing the sensing member 400 and reducing the weight thereof.

The first bridge 412 may have a width L1. The second bridge 520 may have a width L2. The width L2 of the second bridge 520 may be formed to be greater than the width L1 of the first bridge 412. In this case, when viewed from the above (in the +Z direction), the second bridge 520 may be configured to cover the first bridge 412.

When the first bridge 412 and the second bridge 520 are configured as described above, the second bridge 520 may support the first bridge 412 more firmly, so that the rigidity of the sensing member 400 may be further reinforced.

Hereinafter, referring back to FIG. 5, a battery pack 10 according to another embodiment of the present disclosure will be described in detail. In the battery pack 10 according to another embodiment of the present disclosure, the bus-bar assembly 200 may be coupled to the battery cell 110 and the sensing assembly 300, and the bus-bar assembly 200 may be pre-coupled to the sensing assembly 300 and then provided before being coupled to the battery cell 110.

Specifically, in the battery pack 10, the battery cell 110 of the cell array structure 100 and the bus-bar assembly 200 may be coupled, and the bus-bar assembly 200 may be coupled to the sensing assembly 300. That is, the battery cell 110 of the cell array structure 100, the bus-bar assembly 200, and the sensing assembly 300 may be coupled to each other. For example, as described above, the battery cell 110 and the bus-bar assembly 200 may be welded, and the bus-bar assembly 200 and the sensing assembly 300 may be welded.

In this case, the process required for assembling the battery pack 10 may be reduced, so that the assembling efficiency of the battery pack 10 may be improved. Meanwhile, since the sensing assembly 300 coupled to the bus-bar assembly 200 is provided, the support member 500 of the sensing assembly 300 may also reinforce the rigidity of the bus-bar assembly 200. As a result, when assembling the battery pack 10, the support member 500 may reinforce the rigidity of the bus-bar assembly 200, thereby preventing the bus-bar assembly 200 from being deformed or becoming bendy, thereby improving the assembly efficiency of the battery pack 10 and significantly reducing the failure rate.

The bus-bar assembly 200 may include a plurality of connection bus-bars 211 and 212. Specifically, as described above, the bus-bar assembly 200 may include a sub-bus-bar unit 210, and the sub-bus-bar unit 210 may include a plurality of connection bus-bars 211 and 212, such as two-way connection bus-bars 211 and one-way connection bus-bars 212. The sensing assembly 300 may be coupled to the plurality of connection bus-bars. Preferably, the sensing assembly 300 may be coupled to all of the plurality of connection bus-bars.

The cell array structure 100 may be configured in a large area to improve energy density. The sub-bus-bar unit 210 may include a large number of connection bus-bars 211 and 212 corresponding to the large-area cell array structure 100. In the case where the sub-bus-bar unit 210 includes a large number of connection bus-bars 211 and 212 as described above, the sub-bus-bar unit 210 is most likely to be deformed or become bendy when assembling the battery pack 10.

However, as described above, if the sensing assembly 300 is coupled to the plurality of connecting bus-bars 211 and 212, the sensing assembly 300 may stably support the bus-bar assembly 200 with high rigidity, so that the energy density of the battery pack 10 may be maximized, while improving the assembly efficiency of the battery pack 10 and reducing the failure rate of the battery pack 10.

Referring back to FIG. 1, a pack case 600 of a battery pack 10 according to an embodiment of the present disclosure will be described in detail. The battery pack 10 according to the present disclosure may include a pack case 600. The pack case 600 may be configured to store the cell array structure 100. A storage space may be formed inside the pack case 600 to store the cell array structure 100. The pack case 600 may include a configuration of a side wall, a bottom plate, and a pack lid.

Referring back to FIG. 6, the cell array structure 100 will be described in more detail. The cell array structure 100 may further include a cooling unit 140. The cooling unit 140 may be configured to cool the plurality of battery cells 110 and may be provided in contact with the side of the battery cell 110. The cooling unit 140 may be disposed between two adjacent battery cell 110 rows. The cooling unit 140 may be configured to extend along the longitudinal direction (X-axis direction) of the cell array structure 100.

Meanwhile, the battery pack 10 according to the present disclosure, although not shown, may further include various devices for controlling the charging and discharging of battery cells 100, such as a BMS (Battery Management System), a current sensor, and a fuse,

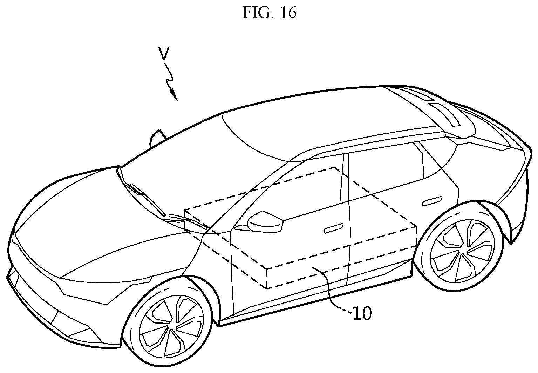

FIG. 16 is a drawing illustrating a vehicle according to an embodiment of the present disclosure.

Referring to FIG. 16 below, a battery pack 10 according to the present disclosure may be applied to a vehicle V such as an electric vehicle or a hybrid vehicle. That is, a vehicle V according to the present disclosure may include the battery pack 10 according to the present disclosure. The battery pack 10 may be installed in the body frame under the vehicle seat or a trunk space. In addition, the vehicle V according to an embodiment of the present disclosure may further include various other components included in the vehicle, in addition to the battery pack 10. For example, the vehicle V according to an embodiment of the present disclosure may further include a vehicle body, a motor, a control device such as an ECU (electronic control unit), in addition to the battery pack 10 according to an embodiment of the present disclosure.

In addition, it is obvious that the battery pack 10 according to an embodiment of the present disclosure may be provided in other devices, apparatuses, and facilities, such as energy storage systems that use secondary batteries, in addition to the vehicle V.

Meanwhile, although terms indicating directions such as up, down, left, right, front, and back are used in this specification, it is obvious to those skilled in the art to which the present disclosure pertains that these terms are only for convenience of explanation with reference the relevant drawings and may vary depending on the position of the target object or the position of the observer.

As described above, although the present disclosure has been described with reference to limited embodiments and drawings, the present disclosure is not limited thereto, and various modifications and variations are possible without departing from the technical idea of the present disclosure and the scope of equivalence of the claims to be described below by those skilled in the art to which the present disclosure pertains.

### [Description of Reference numerals]

10: battery pack
100: cell array structure
110: battery cell
111: positive electrode
112: negative electrode
120: side wall
130: side structure
140: cooling unit
200: bus-bar assembly
210: sub-bus-bar unit
211: two-way connection bus-bar
212: one-way connection bus-bar
213: positive-electrode connection portion
214: negative-electrode connection portion
220: first bus-bar cover
221: first guide opening
222: welding opening
230: second bus-bar cover
231: second guide opening
300: sensing assembly
400: sensing member
410: sensing branch
411: first perimeter
412: first bridge
420: connecting portion
430: connector
500: support member
510: second perimeter
520: second bridge
600: pack case
W1: first weld
W2: second weld
N: metal plate
V: vehicle

## Claims

1. A battery pack comprising:
a plurality of battery cells;
a bus-bar assembly connected to the battery cells; and
at least one sensing assembly connected to the bus-bar assembly,
wherein the sensing assembly comprises:
a sensing member comprising at least one sensing branch configured to sense at least some of the plurality of battery cells; and
at least one support member coupled to the sensing branch and configured to support the sensing branch.

2. The battery pack according to claim 1,
wherein the sensing assembly and the bus-bar assembly are configured as an integrated assembly.

3. The battery pack according to claim 1,
wherein the sensing member is a flexible printed circuit board.

4. The battery pack according to claim 1,
wherein the support member comprises an insulating material having rigidity.

5. The battery pack according to claim 1,
wherein the support member and the sensing branch are configured in shapes corresponding to each other.

6. The battery pack according to claim 1,
wherein the support member is manufactured by injection molding.

7. The battery pack according to claim 1,
wherein the support member and the sensing branch are bonded to each other.

8. The battery pack according to claim 1,
wherein the sensing branch is formed to extend along one direction, and
wherein the support member is formed to extend along a longitudinal direction of the sensing branch.

9. The battery pack according to claim 1,
wherein the support member is disposed on the opposite side of the bus-bar assembly with respect to the sensing branch.

10. The battery pack according to claim 1,
wherein the sensing branch
comprises a first perimeter configured to expose an electrode of the battery cell to the outside and surround the electrode of the battery cell, and
wherein the support member comprises a second perimeter having a shape corresponding to the first perimeter.

11. The battery pack according to claim 10,
wherein the bus-bar assembly
comprises a sub-bus-bar unit connected to the electrode of the battery cell,
wherein the sensing branch and the sub-bus-bar unit are welded to each other at a first weld,
wherein the sub-bus-bar unit and the electrode of the battery cell are welded to each other at a second weld, and
wherein the first perimeter and the second perimeter do not cover the first weld and the second weld.

12. The battery pack according to claim 11,
wherein the sensing branch comprises a metal plate configured to guide welding connection with the sub-bus-bar unit, and
wherein the support member is configured to support the metal plate.

13. The battery pack according to claim 12,
wherein the metal plate is configured as a nickel plate.

14. The battery pack according to claim 10,
wherein the sensing branch comprises:
a plurality of the first perimeters arranged in a row; and
at least one first bridge configured to connect the plurality of the first perimeters, and
wherein the support member comprises:
a plurality of the second perimeters corresponding to the plurality of first perimeters; and
at least one second bridge corresponding to the at least one first bridge.

15. The battery pack according to claim 14,
wherein the width of the second bridge is formed to be greater than the width of the first bridge.

16. The battery pack according to claim 1,
wherein the bus-bar assembly is coupled to the battery cell and the sensing assembly, and
is pre-coupled to the sensing assembly and then provided before being coupled to the battery cell.

17. The battery pack according to claim 16,
wherein the bus-bar assembly
comprises a sub-bus-bar unit comprising a plurality of connection bus-bars connected to the electrodes of the battery cell, and
wherein the sensing assembly
is coupled to the plurality of connection bus-bars.

18. A vehicle comprising at least one battery pack according to any one of claims 1 to
